(19) Europäisches Patentamt / European Patent Office / Office européen des brevets

(11) **EP 3 678 297 A1**

(12) **EUROPEAN PATENT APPLICATION**
published in accordance with Art. 153(4) EPC

(43) Date of publication:
**08.07.2020 Bulletin 2020/28**

(51) Int Cl.:
***H03M 13/29*** (2006.01)

(21) Application number: **18870539.6**

(22) Date of filing: **25.10.2018**

(86) International application number:
**PCT/CN2018/111970**

(87) International publication number:
**WO 2019/080912 (02.05.2019 Gazette 2019/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.10.2017  CN 201711010670**

(71) Applicant: ZTE Corporation
Shenzhen, Guangdong 518057 (CN)

(72) Inventors:
• **SUN, Erkun**
  **Shenzhen**
  **Guangdong 518057 (CN)**
• **CAI, Yi**
  **Shenzhen**
  **Guangdong 518057 (CN)**
• **WANG, Weiming**
  **Shenzhen**
  **Guangdong 518057 (CN)**
• **YIN, Junjie**
  **Shenzhen**
  **Guangdong 518057 (CN)**

(74) Representative: **Baudler, Ron**
  **Canzler & Bergmeier**
  **Patentanwälte Partnerschaft mbB**
  **Friedrich-Ebert-Straße 84**
  **85055 Ingolstadt (DE)**

(54) **TURBO PRODUCT CODE DECODING METHOD, DEVICE AND COMPUTER READABLE STORAGE MEDIUM**

(57) Provided in the present disclosure are a method and device for decoding a Turbo product code, and a computer-readable storage medium. The method includes: acquiring a received codeword and a code pattern of the Turbo product code; determining a reduced error mode set according to the code pattern, a number of unreliable bits, and a reduced number of error bits, where the reduced number of error bits is less than the number of unreliable bits; calculating an optimal codeword according to the reduced error mode set and the received codeword; calculating extrinsic information by using a decoding algorithm according to the optimal codeword; and performing iterative computation according to the extrinsic information and a preset number of iterations to obtain a decoding result of the received codeword.

FIG. 1

Printed by Jouve, 75001 PARIS (FR)

**Description**

**TECHNICAL FIELD**

The present disclosure relates to, but is not limited to, the field of error correction control coding techniques.

**BACKGROUND**

In the development of channel coding, people are always searching for a coding method with a lower error rate and tolerable decoding complexity. As one of the representatives of the soft-input soft-output iterative decoding algorithm, the Turbo code has become a hot spot of research in the channel coding field in recent two decades because of having an error correction performance very close to the Shannon limit.

Among decoding methods of the Turbo code, Kaneko algorithm is an algorithm that can dynamically reduce the search space when candidate codewords are generated in order to reduce complexity. This algorithm uses conditions of optimal candidate codeword correlated differences to guide a direction for further searching, or to terminate the decoding process when the most likely codeword is found. The Kaneko algorithm implements maximum likelihood decoding. Although the Kaneko algorithm can dynamically reduce the search space, the complexity of the algorithm is still very high.

**SUMMARY**

According to an aspect of the present disclosure, there is provided a method for decoding a Turbo product code, including: acquiring a received codeword and a code pattern of the Turbo product code; determining a reduced error mode set according to the code pattern, a number of unreliable bits, and a reduced number of error bits, where the reduced number of error bits is less than the number of unreliable bits; calculating an optimal codeword according to the reduced error mode set and the received codeword; calculating extrinsic information by using a decoding algorithm according to the optimal codeword; and performing iterative computation according to the extrinsic information and a preset number of iterations to obtain a decoding result of the received codeword.

The present disclosure further provides a device for decoding a Turbo product code, including: an acquiring module configured to acquire a received codeword and a code pattern of the Turbo product code; a reduced error mode determining module configured to determine a reduced error mode set according to the code pattern, a number of unreliable bits, and a reduced number of error bits, where the reduced number of error bits is less than the number of unreliable bits; an optimal codeword calculation module configured to calculate an optimal codeword according to the reduced error mode set and the received codeword; an extrinsic information calculation module configured to calculate extrinsic information by using a decoding algorithm according to the optimal codeword; and a decoding result output module configured to perform iterative computation according to the extrinsic information and a preset number of iterations to obtain a decoding result of the received codeword.

The present disclosure further provides a device for decoding a Turbo product code, including a memory and a processor, the memory having a computer program stored thereon which, when executed by the processor, causes the processor to perform the method for decoding a Turbo product code according to the present disclosure.

The present disclosure further provides a computer-readable storage medium having one or more programs stored thereon which, when executed by one or more processors, causes the one or more processors to implement the method for decoding a Turbo product code according to the present disclosure.

The above description is merely an overview of the technical solutions of the present disclosure, and for better clarity of the technical means of the present disclosure so that the present disclosure can be implemented in accordance with the content of the description, and for better understanding of the above and other objects, features and advantages of the present disclosure, the specific embodiments of the present disclosure are recited below.

**BRIEF DESCRIPTION OF THE DRAWINGS**

Various other advantages and benefits will become apparent to those ordinary skilled in the art from reading the following detailed description of embodiments. The drawings are only for the purpose of illustrating the embodiments and are not to be construed as limiting thereto. Throughout the drawings, the same reference numbers represent the same components. In the drawings:

FIG. 1 is a flowchart of a method for decoding a Turbo product code according to an embodiment of the present disclosure;
FIG. 2 is a flowchart illustrating processing of an optimal codeword in a method for decoding a Turbo product code according to an embodiment of the present disclosure;

FIG. 3 is a flowchart of a method for decoding a Turbo product code in which competitive codewords is considered according to an embodiment of the present disclosure;

FIG. 4 is a flowchart of a method for decoding a Turbo product code according to another embodiment of the present disclosure;

FIG. 5 is a diagram illustrating extrinsic information calculation in a method for decoding a Turbo product code according to an embodiment of the present disclosure; and

FIG. 6 is a schematic block diagram of a device for decoding a Turbo product code according to an embodiment of the present disclosure.

## DETAILED DESCRIPTION

Exemplary embodiments of the present disclosure will be described in more detail below with reference to the accompanying drawings. While exemplary embodiments of the disclosure are shown in the drawings, it should be understood that the disclosure may be embodied in various forms and should not be limited to the embodiments set forth herein. Rather, these embodiments are provided so that this disclosure will be thoroughly understood, and will fully convey the scope of the disclosure to those skilled in the art.

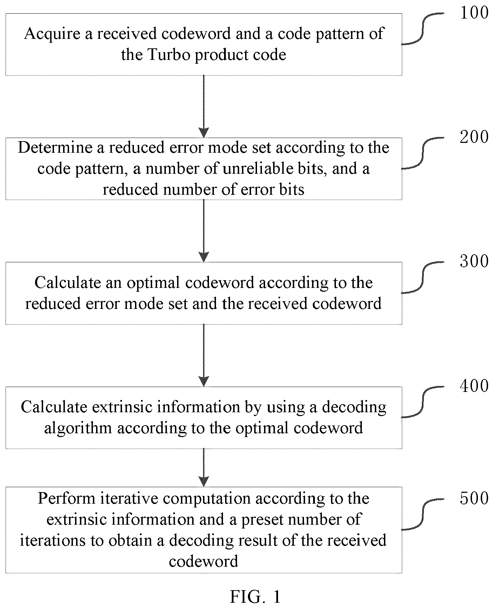

FIG. 1 is a flowchart of a method for decoding a Turbo product code according to an embodiment of the present disclosure.

As shown in FIG. 1, a method for decoding a Turbo product code according to an embodiment of the present disclosure may include steps 100 to 500.

At step 100, a received codeword and a code pattern of the Turbo product code are acquired.

By arranging two or more groups of codeword codes into a two-dimensional matrix or a multi-dimensional matrix, the Turbo product code constructs a product code having minimum distance characteristic for subcodes. The code pattern of the Turbo product code includes (128, 120) × (128, 120), (128, 127) × (128, 127), (64, 57) × (64, 57), (32, 26) × (16, 15) × (8, 7), and the like. When a transmitting end transmits information, the Turbo product code is transmitted serially in rows bit by bit. At the receiving end, the received serial sequence is converted into a two-dimensional matrix form, and decoding is carried out by means of a matrix structure. The decoding complexity and decoding delay of the Turbo product code depend on the code pattern of the subcodes, and linearly increase with construction complexity and decoding complexity of the subcodes. Since the code pattern of the received codeword cannot be determined according to the received codeword, the received codeword and the code pattern need to be acquired simultaneously for subsequent decoding.

At step 200, a reduced error mode set is determined according to the code pattern, a number of unreliable bits, and a reduced number of error bits, where the reduced number of error bits is less than the number of unreliable bits.

Firstly, an error mode set is acquired according to the code pattern and the number of unreliable bits, and then the reduced error mode set is acquired in the error mode set according to the reduced number of error bits. In practical applications, the number of error modes in the reduced error mode set may be controlled according to the number of unreliable bits and the reduced number of error bits. For example, if $n$ unreliable bits are selected according to the code pattern (i.e., the number of unreliable bits is n), there will be $2^n$ possible unreliable modes (i.e., error mode sets), and the error modes may be reduced without affecting the performance. Various error modes including 1 bit, 2 bits ... k bits of the least reliable errors (k<n, i.e., the reduced number of error bits is k) are selected so that the number of error modes is reduced to $C_{n+}^1 C_{n+}^2 + \cdots + C_n^k$.

Assuming that the number of unreliable bits is determined to be 8 (i.e., n = 8) according to the complexity, then the number of error modes is $2^8 = 256$ when not reduced. If the reduced number of error bits is 4 (i.e., k = 4), and all 0 codewords are added, then the number of error modes after reduction is $C_{8+}^1 C_{8+}^2 C_{8+}^3 C_8^4 + 1 = 163$.

At step 300, an optimal codeword is calculated according to the reduced error mode set and the received codeword.

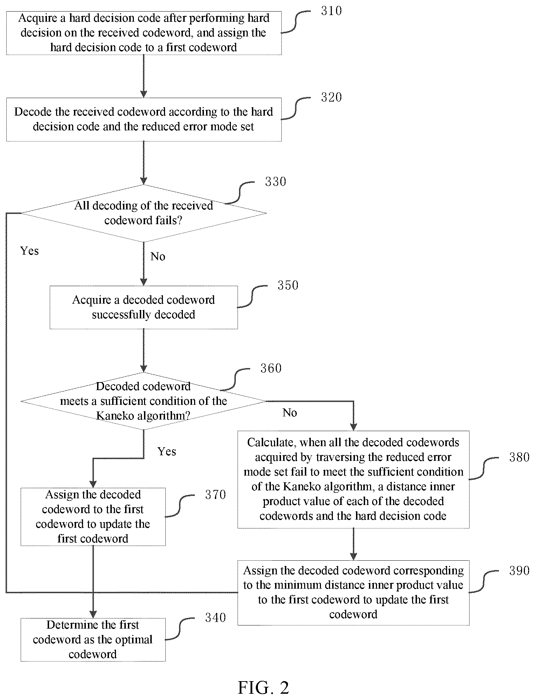

Since the error modes in the reduced error mode set are greatly reduced, and in order to improve accuracy of the obtained optimal codeword, when the optimal codeword is calculated according to the reduced error mode set and the received codeword, processing on the optimal codeword is added when decoding cannot be performed after traversing all the reduced error modes. This processing will be described in detail below with reference to FIG. 2.

At step 400, extrinsic information is calculated by using a decoding algorithm according to the optimal codeword.

The decoding algorithm may include a soft-input soft-output algorithm (SISO algorithm) and a Euclidean distance-based algorithm (DBD algorithm). The extrinsic information is decoded soft output information.

At step 500, iterative computation is performed according to the extrinsic information and a preset number of iterations to obtain a decoding result of the received codeword.

Decoding iterative computation for rows and columns is performed according to the extrinsic information and the preset number of iterations, and then hard decision is performed on the received codeword after the iteration is completed to output a decoding result. The soft input formula of the row or column iterative decoder is as follows, where m is the preset number of iterations:

$$[R(m)] = [R] + \alpha(m)[W(m)]$$

According to the method for decoding a Turbo product code of the embodiment, the reduced error mode set is determined according to the number of unreliable bits and the reduced number of error bits, the optimal codeword is obtained according to the received codeword and the reduced error mode set, extrinsic information is calculated by using a decoding algorithm, and the decoding result is acquired by using the extrinsic information through iterative computation. Since the number of error modes is reduced, the complexity of the decoding algorithm for the Turbo product code is reduced, and the Kaneko algorithm with the maximum likelihood decoding is used to obtain improved decoding performance.

FIG. 2 is a flowchart illustrating processing of an optimal codeword in a method for decoding a Turbo product code according to an embodiment of the present disclosure.

As shown in FIG. 2, a method for decoding a Turbo product code according to an embodiment of the present disclosure may include steps 310 to 390.

At step 310, a hard decision code is acquired after performing hard decision on a received codeword, and the hard decision code is assigned to a first codeword.

At step 320, the received codeword is decoded according to the hard decision code and the reduced error mode set.

For example, BCH decoding may be performed respectively after bitwise xor between the hard decision code and each of the error modes in the reduced error mode set.

At step 330, it is determined whether all decoding of the received codeword fails, if yes, proceed to step 340, and if no, proceed to step 350.

At step 340, the first codeword is determined as the optimal codeword.

For example, in a case that all decoding of the received codeword fails, the first codeword assigned with the hard decision code may be taken as the final optimal codeword.

At step 350, a decoded codeword successfully decoded is acquired.

At step 360, it is determined whether the decoded codeword meets a sufficient condition of the Kaneko algorithm, if yes, proceed to step 370, and if no, proceed to step 380.

At step 370, the decoded codeword is assigned to the first codeword to update the first codeword, and then proceed to step 340.

For example, a decoded codeword meeting a sufficient condition of the Kaneko algorithm may be assigned to the first codeword as the optimal codeword.

At step 380, when all the decoded codewords acquired by traversing the reduced error mode set fail to meet the sufficient condition of the Kaneko algorithm, a distance inner product value of each of the decoded codewords and the hard decision code is calculated.

At step 390, the decoded codeword corresponding to the minimum distance inner product value is assigned to the first codeword to update the first codeword, and then proceed to step 340.

According to the method for decoding a Turbo product code of the embodiment, when all decoding of the received codeword fails, the hard decision code of the received codeword is assigned to the optimal codeword. In addition, when all the decoded codewords acquired by traversing the reduced error mode set fail to meet the sufficient condition of the Kaneko algorithm, the decoded codeword with the minimum distance from the hard decision code is assigned to the optimal codeword. Therefore, under the condition of reducing error modes, acquisition of the optimal codeword is more perfect and reliable while the decoding complexity of the Turbo product code is greatly reduced.

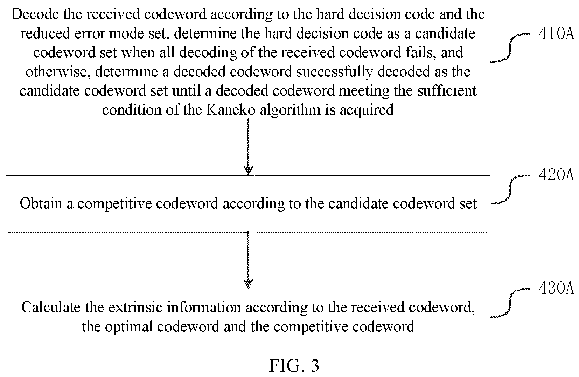

FIG. 3 is a flowchart of a method for decoding a Turbo product code in which competitive codewords is considered according to an embodiment of the present disclosure.

As shown in FIG. 3, a method for decoding a Turbo product code according to an embodiment of the present disclosure may include steps 410A to 430A.

At step 410A, the received codeword is decoded according to the hard decision code and the reduced error mode set, the hard decision code is determined as a candidate codeword set when all decoding of the received codeword fails, and otherwise, a decoded codeword successfully decoded is determined as the candidate codeword set until a decoded codeword meeting the sufficient condition of the Kaneko algorithm is acquired.

The hard decision code may be assigned to the optimal codeword, and BCH decoding is performed respectively after bitwise xor between the hard decision code and each of the error modes in the reduced error mode set. If all decoding fails, the optimal codeword is the hard decision code, and the candidate codeword set includes only the hard decision code. If the decoded codeword successfully decoded meets the sufficient condition of the Kaneko algorithm, the decoded codeword is assigned to the optimal codeword and output, where the candidate codeword set includes all decoded codewords successfully decoded by BCH before the optimal codeword is found. If there is no decoded codeword meeting the condition, the decoded codeword with the minimum distance from the hard decision code is assigned to the optimal codeword and output, and the candidate codeword set includes all decoded codewords successfully decoded by BCH.

At step 420A, a competitive codeword is obtained according to the candidate codeword set.

According to an embodiment of the present disclosure, the competitive codeword needs to satisfy two conditions at the same time: Condition 1, having a minimum Euclidean distance with the received codeword; and Condition 2, $c_j \neq d_j$, where $c_j$ is a code element at the $j^{th}$ bit of the competitive codeword, and $d_j$ is a code element at the $j^{th}$ bit of the optimal codeword.

Condition 2 is determined first by finding each sequence of $c_j \neq d_j$ in the candidate codeword set, and then searching for a sequence having a maximum correlation value with the received codeword in each found sequence as the competitive codeword.

At step 430A, the extrinsic information is calculated according to the received codeword, the optimal codeword and the competitive codeword.

If there is the competitive codeword, then:

$$\omega_j = \frac{|R-C|^2 - |R-D|^2}{4} \times d_j - r_j \; ;$$

if there is no competitive codeword, then:

$$\omega_j = d_j - r_j ,$$

where $w_j$ is a code element at the $j^{th}$ bit of the extrinsic information, $r_j$ is a code element at the $j^{th}$ bit of the received codeword, R is the received codeword, C is the competitive codeword, and D is the optimal codeword.

In this embodiment, the optimal codeword and the competitive codeword are acquired in the reduced error mode, various conditions in the decoding process, particularly the case where all decoding of the received codeword fails are considered, and the extrinsic information is calculated through the SISO algorithm, which realizes decoding of the Turbo product code in the reduced error mode, reduces the complexity of operation, and improves the decoding performance, and thus is very suitable for a system with high performance and high throughput due to the good compromise between complexity and performance.

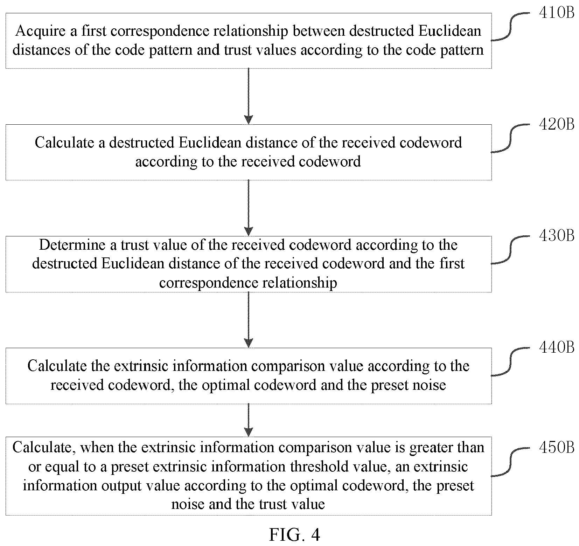

FIG. 4 is a flowchart of a method for decoding a Turbo product code according to another embodiment of the present disclosure.

As shown in FIG. 4, a method for decoding a Turbo product code according to an embodiment of the present disclosure may include steps 410B to 450B.

At step 410B, a first correspondence relationship is acquired according to the code pattern, the first correspondence relationship is a correspondence relationship between destructed Euclidean distances of the code pattern and trust values.

Table 1 shows a table of destructed Euclidean distances of extended BCH codes (64, 51) versus trust values.

Table1:

| Destructed Euclidean distance ( $Dist_{des}$) | <9 | 9 | 10 | 11 | 12 | 13 | 14 | >14 |
|---|---|---|---|---|---|---|---|---|
| Trust value ($\Phi$) | 0.99 | 0.93 | 0.90 | 0.82 | 0.65 | 0.42 | 0.21 | 0.00 |

At step 420B, a destructed Euclidean distance of the received codeword is calculated according to the received codeword.

At step 430B, a trust value of the received codeword is determined according to the destructed Euclidean distance of the received codeword and the first correspondence relationship.

At step 440B, the extrinsic information comparison value is calculated according to the received codeword, the optimal codeword and the preset noise.

The extrinsic information comparison value may be $\exp(2r_jd_j / \sigma^2)$, where $d_j$ is a code element at the $j^{th}$ bit of the optimal codeword, $r_j$ is a code element at the $j^{th}$ bit of the received codeword, and $\sigma$ is preset noise.

In the actual decoding process, the conventional SISO algorithm has no competitive codeword under most conditions so that the calculation complexity is lower when calculating the extrinsic information, while the DBD algorithm has a uniform formula in calculation so that the calculation complexity is higher. The formula for calculating the extrinsic information by the DBD algorithm is:

$$\omega_j = d_j \cdot \left( \frac{\sigma^2}{2} \ln\left( \frac{\phi + \exp\left(2r_jd_j / \sigma^2\right)}{1-\phi} \right) - r_jd_j \right) ,$$

where $\Phi$ is the trust value.

The above formula can be simplified as:

$$\omega_j = d_j \frac{\sigma^2}{2} (\ln[\phi + \exp(2r_jd_j / \sigma^2)] - \ln(1-\phi)) - r_j .$$

In most cases, $d_j$ has the same sign as $r_j$ and $\exp(2r_jd_j / \sigma^2)$ is very large, while $\Phi$ is a positive value smaller than 1.

At step 450B, when the extrinsic information comparison value is greater than or equal to a preset extrinsic information threshold value, an extrinsic information output value is calculated according to the optimal codeword, the preset noise and the trust value.

That is, an extrinsic information threshold value may be set, and when the extrinsic information comparison value exceeds the extrinsic information threshold value, the above formula for calculating the extrinsic information by the DBD algorithm may be simplified as:

$$\omega_j = -d_j \frac{\sigma^2}{2} \ln(1-\phi) .$$

On the other hand, when the extrinsic information comparison value is smaller than the threshold value, the above formula for calculating the extrinsic information by the DBD algorithm remains unchanged.

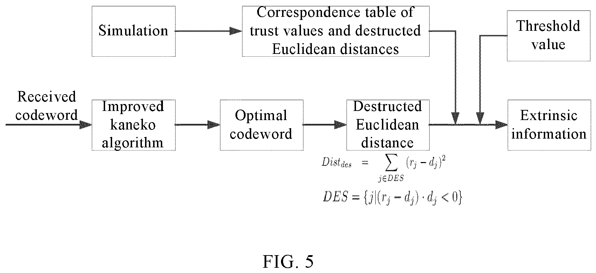

FIG. 5 is a diagram illustrating extrinsic information calculation in a method for decoding a Turbo product code according to an embodiment of the present disclosure, which can clearly describe division of the steps of the calculation method for extrinsic information according to an embodiment of the present disclosure.

In this embodiment, in the decoding process of calculating the extrinsic information according to the optimal codeword, the correspondence relationship between destructed Euclidean distances and trust values is firstly acquired according to the code pattern, then the trust value of the received codeword is determined according to the optimal codeword, and then a simplified extrinsic information comparison value is calculated according to the trust value. When the calculated extrinsic information comparison value is greater than the preset threshold value, the calculation formula of the extrinsic information is simplified.

According to the method for decoding a Turbo product code of the embodiment, the complexity of the decoding operation is reduced, and the decoding performance is improved, and thus it is very suitable for a system with high performance and high throughput due to the good compromise between complexity and performance.

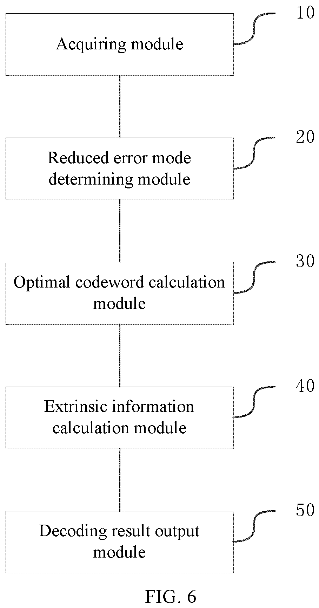

FIG. 6 is a schematic block diagram of a device for decoding a Turbo product code according to an embodiment of the present disclosure.

As shown in FIG. 6, a device for decoding a Turbo product code according to an embodiment of the present disclosure may include an acquiring module 10, a reduced error mode determining module 20, an optimal codeword calculation module 30, an extrinsic information calculation module 40, and a decoding result output module 50.

The acquiring module 10 is configured to acquire a received codeword and a code pattern of the Turbo product code.

The reduced error mode determining module 20 is configured to determine a reduced error mode set according to the code pattern, a number of unreliable bits, and a reduced number of error bits, where the reduced number of error bits is less than the number of unreliable bits. The reduced error mode determining module 20 may be configured to: acquire the number of unreliable bits according to the code pattern, and acquire an unreliable mode set according to the number of unreliable bits; and acquire the reduced error mode set from the unreliable mode set according to the reduced number of error bits.

The optimal codeword calculation module 30 is configured to calculate an optimal codeword according to the reduced error mode set and the received codeword. The optimal codeword calculation module 30 may be configured to: acquire a hard decision code after performing hard decision on the received codeword, and assign the hard decision code to a first codeword; decode the received codeword according to the hard decision code and the reduced error mode set; determine the first codeword as an optimal codeword when all decoding of the received codeword fails; acquire a decoded codeword when the received codeword is successfully decoded; determine whether the decoded codeword meets a sufficient condition of the Kaneko algorithm, if so, assign the decoded codeword to the first codeword to update the first codeword, and determine the updated first codeword as the optimal codeword; calculate, when all the decoded codewords acquired by traversing the reduced error mode set fail to meet the sufficient condition of the Kaneko algorithm, a distance inner product value of each of the decoded codewords and the hard decision code; and assign the decoded codeword corresponding to the minimum distance inner product value to the first codeword to update the first codeword, and determine the updated first codeword as the optimal codeword.

The extrinsic information calculation module 40 is configured to calculate extrinsic information by using a decoding algorithm according to the optimal codeword. The extrinsic information calculation module 40 may be configured to: decode the received codeword according to the hard decision code and the reduced error mode set; determine the hard decision code as a candidate codeword set when all decoding of the received codeword fails, and otherwise, determine a decoded codeword successfully decoded as the candidate codeword set until a decoded codeword meeting the sufficient condition of the Kaneko algorithm is acquired; obtain a competitive codeword according to the candidate codeword set; and calculate the extrinsic information according to the received codeword, the optimal codeword and the competitive codeword. The extrinsic information calculation module 40 may be further configured to: acquire a first correspondence relationship between destructed Euclidean distances of the code pattern and trust values according to the code pattern; calculate an extrinsic information comparison value according to the received codeword, the first correspondence relationship and preset noise; and calculate, when the extrinsic information comparison value is greater than or equal to a preset extrinsic information threshold value, an extrinsic information output value according to the optimal codeword, the preset noise and the trust value. The extrinsic information calculation module 40 may be further configured to: calculate a destructed Euclidean distance of the received codeword according to the received codeword; determine a trust value of the received codeword according to the destructed Euclidean distance of the received codeword and the first correspondence relationship; and calculate the extrinsic information comparison value according to the received codeword, the optimal codeword and the preset noise.

The decoding result output module 50 is configured to perform iterative computation according to the extrinsic information and a preset number of iterations to obtain a decoding result of the received codeword.

According to the device for decoding a Turbo product code of the embodiment, the reduced error mode set is determined according to the number of unreliable bits and the reduced number of error bits, the optimal codeword is obtained according to the received codeword and the reduced error mode set, the extrinsic information is calculated by using a decoding algorithm, and the decoding result is acquired by using the extrinsic information through iterative computation. Since the number of error modes is reduced, the complexity of the decoding algorithm for the Turbo product code is reduced, and the Kaneko algorithm with the maximum likelihood decoding is used to obtain improved decoding performance.

In an embodiment of the present disclosure, there is further provided a computer-readable storage medium having one or more programs stored thereon which, when executed by one or more processors, cause the one or more processors to perform the method steps of: acquiring a received codeword and a code pattern of the Turbo product code; determining a reduced error mode set according to the code pattern, a number of unreliable bits, and a reduced number of error bits, where the reduced number of error bits is less than the number of unreliable bits; calculating an optimal codeword according to the reduced error mode set and the received codeword; calculating extrinsic information by using a decoding algorithm according to the optimal codeword; and performing iterative computation according to the extrinsic information and a preset number of iterations to obtain a decoding result of the received codeword.

The storage medium in the embodiment may include, but is not limited to, an ROM, an RAM, a magnetic or optical disk, and the like.

The above are only exemplary embodiments of the present disclosure and not intended to limit the scope of the present disclosure. Any amendments, equivalent substitutions, improvements, etc. within the principle of the disclosure are all included in the scope of the protection defined by the appended claims of the disclosure.

**Claims**

1. A method for decoding a Turbo product code, comprising:

   acquiring a received codeword and a code pattern of the Turbo product code;
   determining a reduced error mode set according to the code pattern, a number of unreliable bits, and a reduced number of error bits, wherein the reduced number of error bits is less than the number of unreliable bits;
   calculating an optimal codeword according to the reduced error mode set and the received codeword;
   calculating extrinsic information by using a decoding algorithm according to the optimal codeword; and
   performing iterative computation according to the extrinsic information and a preset number of iterations to obtain a decoding result of the received codeword.

2. The method for decoding a Turbo product code according to claim 1, wherein the step of determining the reduced error mode set according to the code pattern, the number of unreliable bits, and the reduced number of error bits comprises:

   acquiring the number of unreliable bits according to the code pattern, and acquiring an unreliable mode set according to the number of unreliable bits; and
   acquiring the reduced error mode set from the unreliable mode set according to the reduced number of error bits.

3. The method for decoding a Turbo product code according to claim 1, wherein the step of calculating the optimal codeword according to the reduced error mode set and the received codeword comprises:

   acquiring a hard decision code after performing hard decision on the received codeword, and assigning the hard decision code to a first codeword;
   decoding the received codeword according to the hard decision code and the reduced error mode set; and
   determining the first codeword as the optimal codeword when all decoding of the received codeword fails.

4. The method for decoding a Turbo product code according to claim 3, wherein the step of calculating the optimal codeword according to the reduced error mode set and the received codeword further comprises:

   acquiring a decoded codeword when the received codeword is successfully decoded; and
   determining whether the decoded codeword meets a sufficient condition of the Kaneko algorithm, if so, assigning the decoded codeword to the first codeword to update the first codeword, and determining the updated first codeword as the optimal codeword.

5. The method for decoding a Turbo product code according to claim 4, wherein the step of calculating the optimal codeword according to the reduced error mode set and the received codeword further comprises:

   calculating, when all the decoded codewords acquired by traversing the reduced error mode set fail to meet the sufficient condition of the Kaneko algorithm, a distance inner product value of each of the decoded codewords and the hard decision code; and
   assigning the decoded codeword corresponding to the minimum distance inner product value to the first codeword to update the first codeword, and determining the updated first codeword as the optimal codeword.

6. The method for decoding a Turbo product code according to claim 5, wherein the step of calculating extrinsic information by using the decoding algorithm according to the optimal codeword comprises:

   decoding the received codeword according to the hard decision code and the reduced error mode set;
   determining the hard decision code as a candidate codeword set when all decoding of the received codeword fails, and otherwise, determining a decoded codeword successfully decoded as the candidate codeword set until a decoded codeword meeting the sufficient condition of the Kaneko algorithm is acquired;
   obtaining a competitive codeword according to the candidate codeword set; and
   calculating the extrinsic information according to the received codeword, the optimal codeword and the competitive codeword.

7. The method for decoding a Turbo product code according to claim 1, wherein the step of calculating extrinsic information by using the decoding algorithm according to the optimal codeword comprises:

acquiring a first correspondence relationship between destructed Euclidean distances of the code pattern and trust values according to the code pattern;

calculating an extrinsic information comparison value according to the received codeword, the first correspondence relationship and preset noise; and

calculating, when the extrinsic information comparison value is greater than or equal to a preset extrinsic information threshold value, an extrinsic information output value according to the optimal codeword, the preset noise and the trust value.

8. The method for decoding a Turbo product code according to claim 7, wherein the step of calculating the extrinsic information comparison value according to the received codeword, the first correspondence relationship and the preset noise comprises:

calculating a destructed Euclidean distance of the received codeword according to the received codeword;

determining a trust value of the received codeword according to the destructed Euclidean distance of the received codeword and the first correspondence relationship; and

calculating the extrinsic information comparison value according to the received codeword, the optimal codeword and the preset noise.

9. A device for decoding a Turbo product code, comprising:

an acquiring module configured to acquire a received codeword and a code pattern of the Turbo product code;

a reduced error mode determining module configured to determine a reduced error mode set according to the code pattern, a number of unreliable bits, and a reduced number of error bits, wherein the reduced number of error bits is less than the number of unreliable bits;

an optimal codeword calculation module configured to calculate an optimal codeword according to the reduced error mode set and the received codeword;

an extrinsic information calculation module configured to calculate extrinsic information by using a decoding algorithm according to the optimal codeword; and

a decoding result output module configured to perform iterative computation according to the extrinsic information and a preset number of iterations to obtain a decoding result of the received codeword.

10. The device for decoding a Turbo product code according to claim 9, wherein the reduced error mode determining module is configured to:

acquire the number of unreliable bits according to the code pattern, and acquire an unreliable mode set according to the number of unreliable bits; and

acquire the reduced error mode set from the unreliable mode set according to the reduced number of error bits.

11. The device for decoding a Turbo product code according to claim 9, wherein the optimal codeword calculation module is configured to:

acquire a hard decision code after performing hard decision on the received codeword, and assign the hard decision code to a first codeword;

decode the received codeword according to the hard decision code and the reduced error mode set; and

determine the first codeword as an optimal codeword when all decoding of the received codeword fails.

12. The device for decoding a Turbo product code according to claim 11, wherein the optimal codeword calculation module is further configured to:

acquire a decoded codeword when the received codeword is successfully decoded; and

determine whether the decoded codeword meets a sufficient condition of the Kaneko algorithm, if so, assign the decoded codeword to the first codeword to update the first codeword, and determine the updated first codeword as the optimal codeword.

13. The device for decoding a Turbo product code according to claim 12, wherein the optimal codeword calculation module is further configured to:

calculate, when all the decoded codewords acquired by traversing the reduced error mode set fail to meet the sufficient condition of the Kaneko algorithm, a distance inner product value of each of the decoded codewords and the hard decision code; and

assign the decoded codeword corresponding to the minimum distance inner product value to the first codeword to update the first codeword, and determine the updated first codeword as the optimal codeword.

14. The device for decoding a Turbo product code according to claim 13, wherein the extrinsic information calculation module is configured to:

decode the received codeword according to the hard decision code and the reduced error mode set;
determine the hard decision code as a candidate codeword set when all decoding of the received codeword fails, and otherwise, determine a decoded codeword successfully decoded as the candidate codeword set until a decoded codeword meeting the sufficient condition of the Kaneko algorithm is acquired;
obtain a competitive codeword according to the candidate codeword set; and
calculate the extrinsic information according to the received codeword, the optimal codeword and the competitive codeword.

15. The device for decoding a Turbo product code according to claim 9, wherein the extrinsic information calculation module is configured to:

acquire a first correspondence relationship between destructed Euclidean distances of the code pattern and trust values according to the code pattern;
calculate an extrinsic information comparison value according to the received codeword, the first correspondence relationship and preset noise; and
calculate, when the extrinsic information comparison value is greater than or equal to a preset extrinsic information threshold value, an extrinsic information output value according to the optimal codeword, the preset noise and the trust value.

16. The device for decoding a Turbo product code according to claim 15, wherein the extrinsic information calculation module is further configured to:

calculate a destructed Euclidean distance of the received codeword according to the received codeword;
determine a trust value of the received codeword according to the destructed Euclidean distance of the received codeword and the first correspondence relationship; and
calculate the extrinsic information comparison value according to the received codeword, the optimal codeword and the preset noise.

17. A device for decoding a Turbo product code, comprising a memory and a processor, the memory having a computer program stored thereon which, when executed by the processor, causes the processor to perform the method for decoding a Turbo product code according to any one of claims 1 to 8.

18. A computer-readable storage medium having one or more programs stored thereon which, when executed by one or more processors, cause the one or more processors to perform the method for decoding a Turbo product code according to any one of claims 1 to 8.

Acquire a received codeword and a code pattern of the Turbo product code — 100

Determine a reduced error mode set according to the code pattern, a number of unreliable bits, and a reduced number of error bits — 200

Calculate an optimal codeword according to the reduced error mode set and the received codeword — 300

Calculate extrinsic information by using a decoding algorithm according to the optimal codeword — 400

Perform iterative computation according to the extrinsic information and a preset number of iterations to obtain a decoding result of the received codeword — 500

FIG. 1

Acquire a hard decision code after performing hard decision on the received codeword, and assign the hard decision code to a first codeword — 310

Decode the received codeword according to the hard decision code and the reduced error mode set — 320

All decoding of the received codeword fails? — 330

Yes

No

Acquire a decoded codeword successfully decoded — 350

Decoded codeword meets a sufficient condition of the Kaneko algorithm? — 360

No

Yes

Calculate, when all the decoded codewords acquired by traversing the reduced error mode set fail to meet the sufficient condition of the Kaneko algorithm, a distance inner product value of each of the decoded codewords and the hard decision code — 380

Assign the decoded codeword to the first codeword to update the first codeword — 370

Assign the decoded codeword corresponding to the minimum distance inner product value to the first codeword to update the first codeword — 390

Determine the first codeword as the optimal codeword — 340

FIG. 2

Decode the received codeword according to the hard decision code and the reduced error mode set, determine the hard decision code as a candidate codeword set when all decoding of the received codeword fails, and otherwise, determine a decoded codeword successfully decoded as the candidate codeword set until a decoded codeword meeting the sufficient condition of the Kaneko algorithm is acquired

410A

Obtain a competitive codeword according to the candidate codeword set

420A

Calculate the extrinsic information according to the received codeword, the optimal codeword and the competitive codeword

430A

FIG. 3

Acquire a first correspondence relationship between destructed Euclidean distances of the code pattern and trust values according to the code pattern — 410B

Calculate a destructed Euclidean distance of the received codeword according to the received codeword — 420B

Determine a trust value of the received codeword according to the destructed Euclidean distance of the received codeword and the first correspondence relationship — 430B

Calculate the extrinsic information comparison value according to the received codeword, the optimal codeword and the preset noise — 440B

Calculate, when the extrinsic information comparison value is greater than or equal to a preset extrinsic information threshold value, an extrinsic information output value according to the optimal codeword, the preset noise and the trust value — 450B

FIG. 4

```
                                    ┌──────────────────────────┐          ┌──────────────┐
             ┌──────────────┐       │ Correspondence table of  │          │  Threshold   │
             │  Simulation  │──────▶│ trust values and destructed│────┐    │    value     │
             └──────────────┘       │  Euclidean distances     │    │    └──────────────┘
                                    └──────────────────────────┘    │         │
  Received                                                          │         │
  codeword   ┌──────────────┐   ┌──────────────┐   ┌──────────────┐ │         │   ┌──────────────┐
 ──────────▶ │  Improved    │──▶│   Optimal    │──▶│  Destructed  │─┘         ▼   │  Extrinsic   │
             │   kaneko     │   │  codeword    │   │  Euclidean   │──────────────▶│ information   │
             │  algorithm   │   │              │   │  distance    │               │              │
             └──────────────┘   └──────────────┘   └──────────────┘               └──────────────┘
```

$$Dist_{des} = \sum_{j \in DES} (r_j - d_j)^2$$

$$DES = \{j | (r_j - d_j) \cdot d_j < 0\}$$

FIG. 5

```
┌─────────────────────────────┐
│      Acquiring module       │  ⌇ 10
└─────────────────────────────┘
              │
┌─────────────────────────────┐
│     Reduced error mode      │  ⌇ 20
│     determining module      │
└─────────────────────────────┘
              │
┌─────────────────────────────┐
│  Optimal codeword calculation │  ⌇ 30
│           module            │
└─────────────────────────────┘
              │
┌─────────────────────────────┐
│     Extrinsic information   │  ⌇ 40
│     calculation module      │
└─────────────────────────────┘
              │
┌─────────────────────────────┐
│    Decoding result output   │  ⌇ 50
│           module            │
└─────────────────────────────┘
```

FIG. 6

## INTERNATIONAL SEARCH REPORT

| International application No. |
|---|
| **PCT/CN2018/111970** |

**A.    CLASSIFICATION OF SUBJECT MATTER**

H03M 13/29(2006.01)i

According to International Patent Classification (IPC) or to both national classification and IPC

**B.    FIELDS SEARCHED**

Minimum documentation searched (classification system followed by classification symbols)

H03M13/-

Documentation searched other than minimum documentation to the extent that such documents are included in the fields searched

Electronic data base consulted during the international search (name of data base and, where practicable, search terms used)

USTXT; EPTXT; CNTXT; CNABS; WOTXT; VEN; CNKI: Turbo乘积码, 码字, 码型, 不可靠位数, 缩减错误数, 模式集合, 译码, 最优, 迭代, turbo product code, code word, code type, unreliable number of digits, reduce the number of errors, pattern collection, decode, optimal, iteration

**C.    DOCUMENTS CONSIDERED TO BE RELEVANT**

| Category* | Citation of document, with indication, where appropriate, of the relevant passages | Relevant to claim No. |
|---|---|---|
| A | CN 101777926 A (ZHEJIANG UNIVERSITY) 14 July 2010 (2010-07-14) entire document | 1-18 |
| A | CN 103220007 A (NANJING UNIVERSITY OF AERONAUTICS AND ASTRONAUTICS) 24 July 2013 (2013-07-24) entire document | 1-18 |
| A | CN 106656216 A (HUNAN KEYSHARE COMMUNICATION TECHNOLOGY CO., LTD.) 10 May 2017 (2017-05-10) entire document | 1-18 |
| A | CN 101958720 A (XIDIAN UNIVERSITY) 26 January 2011 (2011-01-26) entire document | 1-18 |
| A | US 2013007555 A1 (MINDSPEED TECHNOLOGIES, INC.) 03 January 2013 (2013-01-03) entire document | 1-18 |

☐ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **28 December 2018** | **18 January 2019** |

| Name and mailing address of the ISA/CN | Authorized officer |
|---|---|
| **State Intellectual Property Office of the P. R. China (ISA/ CN)** **No. 6, Xitucheng Road, Jimenqiao Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2018/111970**

| Patent document cited in search report | | | Publication date (day/month/year) | Patent family member(s) | | | Publication date (day/month/year) |
|---|---|---|---|---|---|---|---|
| CN | 101777926 | A | 14 July 2010 | CN | 101777926 | B | 16 April 2014 |
| CN | 103220007 | A | 24 July 2013 | CN | 103220007 | B | 30 March 2016 |
| CN | 106656216 | A | 10 May 2017 | None | | | |
| CN | 101958720 | A | 26 January 2011 | CN | 101958720 | B | 20 March 2013 |
| US | 2013007555 | A1 | 03 January 2013 | US | 8996948 | B2 | 31 March 2015 |

Form PCT/ISA/210 (patent family annex) (January 2015)